# EUROPEAN PATENT APPLICATION

(11) **EP 1 883 056 A2**
(43) Date of publication of application: **30.01.2008**
(21) Application number: 07112997.7
(22) Date of filing: 24.07.2007
(51) Int. Cl.: G08C 17/02

(54) **System for the analysis and management of the electric power consumption of an electric installation**

(30) Priority: 24.07.2006 IT VI20060233
(71) Applicant: Beghelli S.p.A., 40050 Monteveglio, Bologna (IT)
(72) Inventor: Beghelli, Gian Pietro, 40050 Monteveglio (Bologna) (IT)
(74) Representative: Fusina, Gerolamo

(57) **Abstract**

System for the analysis and management of the electric power consumption of an electric installation, comprising at least one electric power meter device (1), connected to a supply network (2) and installed upstream of electric users (4) whose consumption is metered in a non-differentiated manner, and a group of distributed meters (8', 8", 8'"), each one being connected directly or indirectly via radio (7) through a concentrator device (6) to the principal meter (1) and connected to a specific and determined electric user (5, 9, 10), which is to be metered in a punctual manner.

## Description

The present invention in general regards a system for the analysis and management of the electric power consumption of an electric installation.

More in particular, the invention regards a system for measuring and metering of electric power consumption in a differentiated manner for each single user of an electric installation.

Electric power is traditionally measured by meters connected upstream of the group of users, the object of electric power supply.

In general, the grouping of the users is carried out according to topological criteria and according the ownership of the electric installation.

The groupings are carried out in a rigid manner and are wired during the construction of the electric installation.

This signifies that at a later date it is rather difficult to distinguish groups of users within an electric installation, on which to carry out a selective measurement of the electric power consumption.

This is only possible by differently wiring such users and mounting a separator electric power meter upstream thereof, which causes obvious complications caused by the complexity of the intervention and the considerable cost of raw materials and labour involved.

In addition, the operation is even more complicated if the users which one intends to group together are topologically separate from each other.

The object of the present invention is therefore to overcome the drawbacks described above, and in particular to make a system for analysis and management the electric power consumption of an electric installation, which, integrated within the main energy meter mounted upstream of the electric installation at the supply point, and with the aid of a set of auxiliary meters connected in wireless mode to the main meter, this will easily permit selective metering of the energy consumed by user subsets of the electric installation, in a simply reconfigurable manner, hence permitting the measurement at any moment of the overall energy consumed by the electric installation and the amount simultaneously consumed by each separate subset.

Another object of the present invention is to provide a system for the analysis and management of the electric power consumption of an electric installation in a basically simple manner and at reduced cost, when compared to the advantages to be gained.

These and other aims are achieved by a system for the analysis and management of the electric power consumption of an electric installation according to the appended claim 1; the further claims include other detailed technical characteristics of the system.

In an advantageous manner, the differentiated analysis of the consumption of the various individual users or groups of users permits a differentiated pricing to achieve electric power use policies aimed for example at energy savings; with this aim in mind, the electricity supply dedicated to motive power applications could be priced at a rate that differs from that destined for lighting or heating.

Further characteristics and advantages will be made more apparent from the following description of a preferred, but non-limiting embodiment, of the system for the analysis and management of the electric power consumption of an electric installation, which is the object of the present invention, as well as the appended drawings, wherein:
Figure 1 shows an overall block diagram of the system for the analysis and management of the electric power consumption of an electric installation according to the present invention;
Figure 2 shows an overall block diagram of a principal meter in the most common version, triple phase type, used in the system for the analysis and management of the electric power consumption of an electric installation according to the present invention;
Figure 3 shows an overall block diagram of a concentrator device which may be present in the system for the analysis and management of the electric power consumption of the electric installation according to the present invention;
Figure 4 shows an overall block diagram of a distributed power meter used in the system for the analysis and management of the electric power consumption of the electric installation according to the present invention.

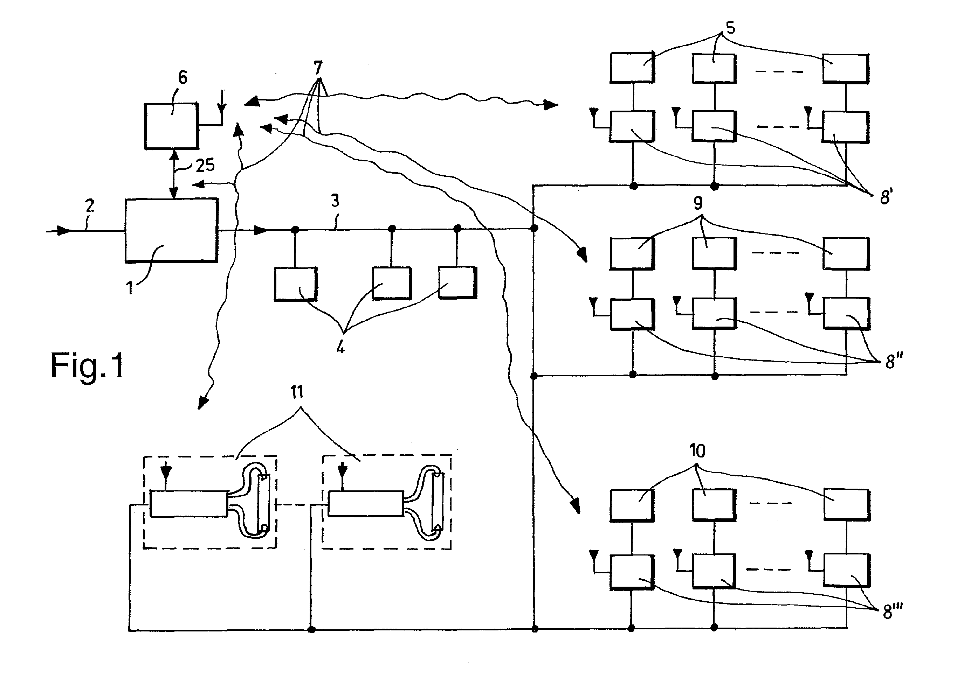

In particular reference to the appended figure 1 that shows the overall block diagram of the system for the analysis and management, which is the object of the present invention, the numeral 1 is used to identify a principal electrical power meter, installed upstream of all the electric users, supplied by a triple phase, low voltage distribution network 2, while the triple phase outlet or the three single phase outlets 3 of the principal meter 1 supply the electric installation.

The numeral 6 identifies a concentrator device, possibly connected to meter 1, through a suitable connecting interface 25, while numeral 4 refers to various general users whose consumption is measured in a non-differentiated manner. The numerals 8', 8", 8' ", identify a series of distributed meters, each one being connected to a specific single electric user for accurate consumption metering.

For example, in the block diagram shown in figure 1, the consumption of the users identified by numeral 5 (of the so-called A type) are measured by the distributed meters 8', that of the users 9 (B type) are measured by the distributed meters 8", and that of the users 10 (C type) are measured by the distributed meters 8"'.

The meters 8', 8", 8'", are connected to the concentrator 6 and to the principal meter 1 in wireless mode, through radio waves 7.

Once again the diagram in figure 1 shows a set of specialised electrical appliances 11, each one incorporating a distributed meter (as an example, figure 1 shows these appliances as a set of lighting appliances 11, each of which is already equipped with its own specific electric power meter).

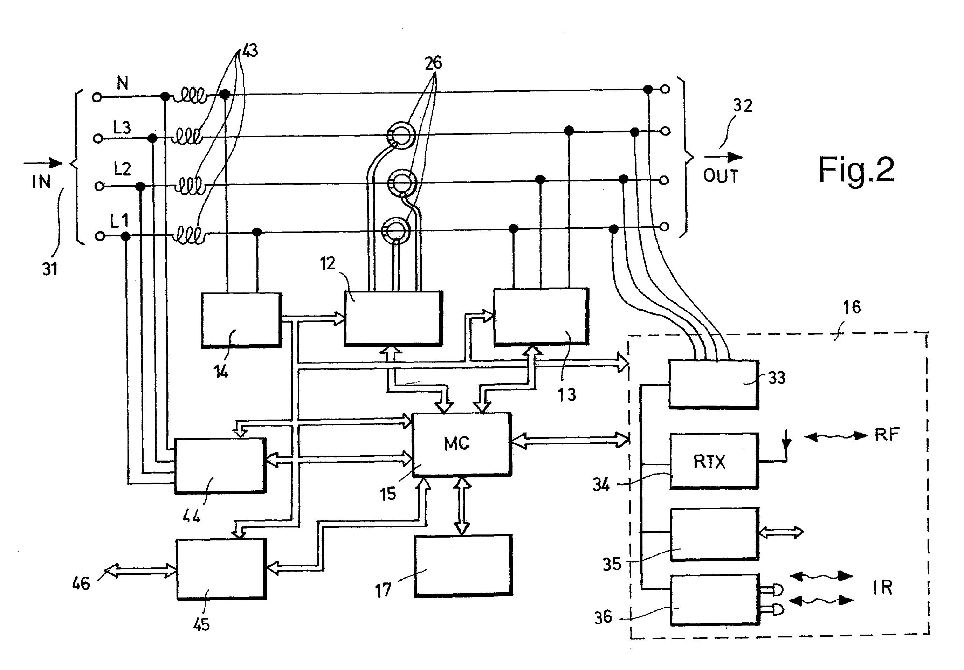

In particular, the block diagram of the principal meter 1, shown in figure 2 in its most common triple phase type version, includes a 4-wire inlet terminal strip 31 (the three phases are identified by L1, L2, L3, and the neutral is shown as N), or alternatively, a 2-wire terminal strip (phase is shown by L and neutral by N) for cases where the principal meter 1 is a single phase type (the diagram is not shown in the appended figures, but is obvious and easy to produce based on the version provided), an outlet 32, three current sensors 26, such as of the toroidal type, suitable amplifier devices and/or conditioners 12 of the current signals, suitable voltage meters 13, suitable insulation filters 43 to separate the power line communication, a power line communication interface 44 for communication towards the power supplier electric power distribution network, a modem 45, with an interface port 46, for example of the type PSTN, ADSL, GSM, GPRS, UMTS, which is used for remote data transmission from meter 1 and for remote control of said meter 1, a microcontroller 15, a supplier 14, that supplies the required power to the meter 1 circuits in order to function, a user interface 17, equipped with one or more displays and one or more push-buttons, and a communication interface 16 for connection to the other parts of the metering system.

The communication interface 16 can be the radio wave type 34, or power line communication type 33, wired type 35, with serial communication, such as RS232, or RS485, or infrared type 36.

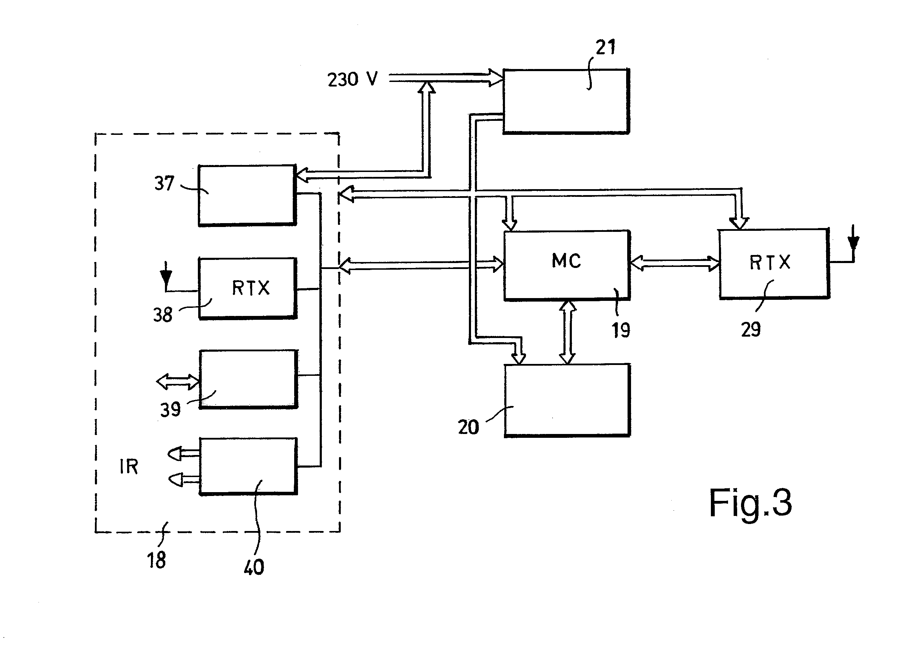

In specific reference to the block diagram of the concentrator device 6 shown in figure 3, it is possible to identify the following:
- a microcontroller 19;
- a communication interface 18 towards the principal meter 1, which can be a radio wave type 38, a power line communication type 37, a wired type 39, with serial type communication such as RS232 or RS485, or an infrared type 40;
- a user interface 20 equipped with a display and push button strip;
- a radio receiver-transmitter 29, to transfer information to and from the rest of the system;
- a power supply unit 21.

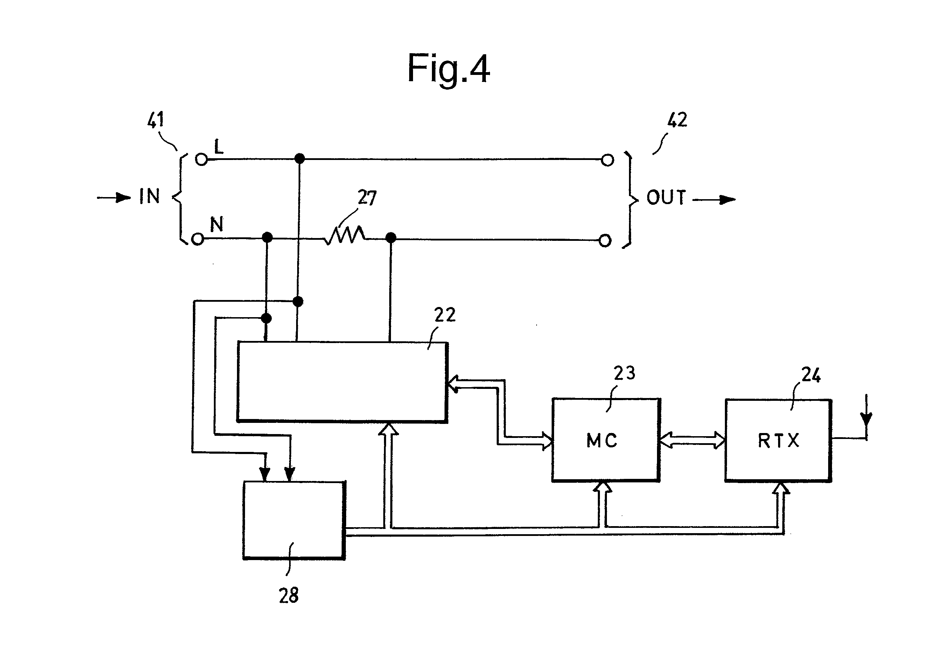

Lastly, with specific reference to figure 4 which shows the block diagram of each distributed energy meter 8', 8", 8' " for measuring the electric power consumed by a single user, the following are included:
- an inlet terminal strip 41;
- an outlet terminal strip 42;
- suitable amplification and/or conditioning circuits 22 for measuring voltage and current absorbed by the user;
- a shunt resistor 27;
- a power supply unit 28;
- a microcontroller 23, which is used to process signals and to measure the total energy consumed and which is used for the management of the data communication to the system;
- a radio receiver-transmitter 24.

The system for the analysis and management of the electric power consumption of an electric installation according to the present invention basically functions as follows:
The principal meter 1 measures the electrical power and the electric power consumed by all the users 4 connected to the triple or single-phase line 3.

Each meter 8', 8", 8' ", measures the electrical power and energy consumed by each single user 5, 9,10, while the concentrator 6 regularly checks all the distributed meters 8', 8", 8' ", and collects the metered consumption data from said meters 8', 8", 8' ", and through interface 25, the principal meter 1 is able to acquire the consumption data from each single user 5, 9, 10, 11 of the electric installation.

This means that the principal meter 1 is regularly provided with the following data:
- the total electric power consumed by the electric installation, the absorbed peak power and instant power;
- the amount of electric power consumed by each single user, 5, 9, 10, 11, plus the peak power and the instant power absorbed by each single user 5, 9, 10, 11;
- the amount of electric power consumed by each group of users that can be defined in the electric installation (such as the group of all the users 5, type A, for example, or all the users 9, type B, etc.) plus the peak power and the instant power absorbed by said groups.

All the data available in meter 1 can then be transferred by means of interface 44 or modem 45 and through connection 46, towards any possible supervision systems connected to the electric power supplier's distribution network 2 or to the public telecommunications networks (such as PSTN, ADSL, GSM, GPRS, UMTS).

The electric power supplier can use this data to implement various pricing policies of the energy supply and/or savings promotions, in relation to the specific user type.

It is obvious that the management of a system such as that described above has immediate access at any time to the data concerning the total electric power consumption, the electric power consumption of each single user, controlled through the distributed meters 8', 8", 8"', the consumption of the electric power of all possible grouping defined during system programming of the users measured by the meters 8', 8", 8' ", and by subtraction, the consumption of all the non-differentiated loads 4 which are not directly controlled by the meters 8', 8", 8' ".

It is obvious that the wireless communication structure obtained through radio waves 7 for example, permits easy and flexible relocation of the distributed meters 8', 8", 8' ", thus making the aforesaid system easy to install, even and above all, in existing electric installations, without the need for costly cabling which could limit the realisation.

In fact, each distributed meter 8', 8", 8' ", is autonomous and is simply inserted in series on the user that it monitors, supplied by the same wiring in series, from which it meters the energy absorbed by the user in question (as shown more clearly in figure 4).

The diagram in figure 2 shows that the microcontroller 15 governs the principal meter 1 by means of interface 16, and in particular, acquires the current and voltage measurement data from the conditioner circuits 12, 13, thus calculating the instant power, the active power, and the reactive power; furthermore, by integrating the instant power, it calculates the energy consumed by the users connected to outlet 32.

The microcontroller 15 then controls the user interface 17, using the push button strip and operating the display in a suitable manner, and lastly controls the communication processing by implementing the communication protocols both towards the electric installation, through interface 16, as well as towards the remote supervision control system, through the power line communication interface 44 or through the modem 45.

The principal meter 1 can be configured through the local interface 17 (push button strip and display), through one of the communication interfaces 16, or through one of the communication interfaces 44 or 46.

All the communication protocols are protected against non-authorised tampering with data, by means of suitable code and/or crypting systems.

The concentrator device 6, shown in figure 3, is governed by the microcontroller 19, which manages the communication protocols towards the principal meter 1 (through interface 18) and towards the system, controlled through the radio receiver-transmitter interface 29.

In particular, the radio receiver-transmitter interface 29 is a FH DSSS type, for example (Frequency Hopping Direct Sequence Spread Spectrum"), which operates in the band between 2,400 and 2,438 GHz, and which can be used all over the world without the need for a license. The use of this communication technique that can be applied at low cost, with integrated dedicated circuits, provides extremely reliable communication, immune to interference and attenuation, and is not very invasive from the viewpoint of emitted power, because (thanks to the spectrum dispersion) with small power peaks it is possible to obtain good performance levels.

The communication protocol with the distributed meters 8', 8", 8' ", is the type with automatic repetition of the data packages among the various devices that make up the system, with dynamic routing and automatic research of the best route in order to reach a specific node of the radio network.

The concentrator device 6 also has a user interface 20 composed of display and push button strip, which are used by the controller 19, in a suitable manner to acquire local commands and to show local visual displays.

The interface 18, which is the same type as the interface 16, implemented in the principal meter 1, can be of various types according to different standards, such as:
- power line communication type 37, such as FSK type for example, and with at least two channels with different frequencies to provide sufficient redundancy in order to avoid any malfunction due to disturbance present on one of the channels;
- radio wave type 38, using FH DSSS type technique for example, (in this case, the physical interface can be the same radio-receiver-transmitter interface 29);
- wired type 39, such as RS232 or RS485, or current loop with different standards;
- infrared 40, such as IRDA type, or according to a different standard.

Each distributed meter 8', 8", 8' ", (figure 4) is governed by a microcontroller 23, which acquires the current and voltage measurement data from the conditioning circuits 22 and calculates the instantaneous power, the active power and the reactive power; furthermore by integrating the instantaneous power, it calculates the energy consumed by the user connected to its outlet 42.

The microcontroller 23 manages the radio communication via the receiver-transmitter 24, using FH DSSS technique and multiple repetition protocol, with dynamic message routing.

Furthermore, the microcontroller 23 provides the principal meter 1 with the locally metered consumption data via radio protocol and locally manages the total energy and elapsed time.

Lastly, inside the microcontroller 23 are two meters which do not zero set their count during power shutdown, and which measure the energy consumed and the time elapsed from the electric installation or since the last zero-setting ordered by the system.

It is obvious that all the functions described have been advantageously performed thanks to radio data transmission and the flexibility of the interfaces for remote data control made available by the energy metering system, which also provides far easier system installation and configuration of the system, making easy realisation even in the case of complex grouping of the single controlled users.

The above description has provided a clear explanation of the characteristics of the analysis and management system for electric power consumption in an electric installation, which is the object of the present invention, as well as clearly identifying all the advantages to be gained.

In particular, it is obvious that all the functions described are performed advantageously via radio data transmission which provides far easier device installation and configuration, making realisation possible by any user, even those without expertise in this field.

Lastly it is also clear that it is possible to introduce variants to the analysis and management system in question while remaining within the context of the principles which form the basic idea of the invention, just as it is also clear that in the embodiment of the invention, the materials, shapes and sizes can be chosen according to different technical necessities.

## Claims

1. System for the analysis and management of the electric power consumption of an electric installation, of the type comprising at least one first electric power meter device (1), connected to a supply network (2) and installed upstream of electric users (4) whose consumption is metered in a non-differentiated manner, **characterised in that** said first electric power meter device (1) is connected via radio (7) to at least a second meter device (8', 8", 8"'), which is connected to one specific and determined electric user (5, 9, 10), whose consumption is metered in a punctual manner.

2. Analysis and management system according to claim 1, **characterised in that** said first electric power meter device (1) presents at least one triple or single phase outlet (3) suitable to power supply the electric installation.

3. Analysis and management system according to claim 1 **characterised in that** said first meter device (1) is connected to at least one concentrator device (6) via at least one interface (25) in a manner to acquire the consumption data of each single user (5, 9, 10, 11) in the electric installation.

4. Analysis and management system according to claim 1, **characterised in that** connected to said outlet (3) of said first electric power meter device (1) is at least one specialised electric appliance (11) that incorporates its own meter device.

5. Analysis and management system according to claim 1 **characterised in that** said first meter device (1) includes a set of current sensors (26), amplifier and/or conditioner devices (12, 13) of the voltage and current signals, at least one first power line communication interface (44) for communication towards the energy supplier electric power distribution network, at least a second communication interface (16) for connection to other parts of the system, at least a modem (45) for remote meter device (1) data transfer, and for the remote control of the said meter device (1), and a system management microcontroller (15).

6. Analysis and management system according to claim 3, **characterised in that** said concentrator device (6) includes a microcontroller (19) to manage the communication protocols towards said first meter device (1), through at least one first communication interface (18), and at least one radio receiver-transmitter (29), for data transfer from and to the rest of the system, said concentrator device (6) being adapted to periodically check said second meter devices (8', 8", 8"').

7. Analysis and management system according to claim 1, **characterised in that** each second meter device (8', 8", 8"') adapted to meter the electric power consumed by a single electric user (5, 9, 10) comprises amplification and/or conditioning devices (22) to measure voltage and current absorbed by the electric user (5, 9, 10), at least one shunt resistor (27), a microcontroller (23) adapted to process signals, to measure the consumed energy and power, and to manage the system data communication, beginning from current and voltage measurement performed by the conditioning circuits (22) of said second meter devices (8', 8", 8"'), and at least one radio receiver-transmitter (24) for communication via radio, through said microcontroller (23), of the locally metered consumption data to said first meter device (1).

8. Analysis and management system according to claim 1, **characterised in that** said first meter device (1) permits detecting the total electric power consumption, the levels of the peak absorbed power and instant power of the electric installation, of every single electric user (4, 5, 9, 10, 11) and of pre-determined groups of electric users belonging to the electric installation.

9. Analysis and management system according to claim 1, **characterised in that** each second meter device (8', 8", 8"') is autonomous and can be inserted in series on the electric user (5, 9, 10, 11) to be controlled.

10. Analysis and management system according to claim 7, **characterised in that** inside said microcontroller (23) are at least two meters which measure the consumed energy and elapsed time, beginning from the electric installation or from the latest zero setting performed by the system.
